# EUROPEAN PATENT APPLICATION

(11) **EP 4 589 185 A1**
(43) Date of publication of application: **23.07.2025**
(21) Application number: 25152353.6
(22) Date of filing: 16.01.2025
(51) Int. Cl.: F16L 5/06, F16L 23/00, F16L 41/02

(54) **THROUGH-WALL PIPING CONNECTOR**

(30) Priority: 16.01.2024 US 202463621354 P
(71) Applicant: Hoffman Enclosures, Inc., Anoka, MN 55303 (US)
(72) Inventor: STAMMER, Scott, Champlin, 55316 (US); BENDTSEN, Gavin, Big Lake, 55309 (US); TURNER, John, Anoka, Minnesota 55303 (US)
(74) Representative: Barker Brettell LLP

(57) **Abstract**

A through-wall connector (100) includes a body (102) defining an outer surface, a first distal end (104), a second distal end (106), and an interior channel. A first connection interface is provided at the first distal end, the first connection interface defining a first opening (108). A second connection interface is provided at the second distal end, the second connection interface defining a second opening (110), the interior channel being defined between the first opening and the second opening. An external threaded section (124) is provided along the outer surface, the external threaded section being received through the aperture when the through-wall connector is installed in the panel. A radial protrusion extends outwardly from the outer surface. A threaded nut (125) sized to receive the threaded section, the threaded nut threadably engaging the external threaded section and contacting the first side of the panel when the through-wall connector is installed in the panel.

## Description

### CROSS-REFERENCE TO RELATED APPLICATIONS

The present application claims priority to United States Provisional Patent Application No. 63/621,354, filed January 16, 2024, the entire contents of which are herein incorporated by reference.

### BACKGROUND

Liquid cooling systems can be provided to cool electrical equipment housed in enclosures. In some cases, cooling systems for electrical equipment can be housed in separate enclosures from the electrical equipment. For example, in some cases a liquid coolant can be cooled through a liquid-to-air heat transfer (e.g., at a liquid-to-air heat exchanger, or a refrigerant-based system for transferring heat from a liquid to an ambient air), and the liquid-to-air heat transfer can require a flow of air through an enclosure. In some cases, enclosure housing electrical equipment can require a greater level of sealing against entry of ambient air, particulate matter, and liquid into the enclosure.

### SUMMARY

The present disclosure relates to liquid entry systems and through-wall connectors for protecting electrical enclosures against fluid and dust entry.

Some examples of the present disclosure provide a through-wall connector including a body, a first connection interface, a second connection interface, an external threaded portion, a radial protrusion, and a threaded nut. The body can define an outer surface, a first distal end, a second distal end, and an interior channel. The first connection interface can be positioned at the first distal end, and can define a first opening. The second connection interface can be positioned at the second distal end, and can define a second opening. The interior channel can be defined between the first opening and the second opening. The external threaded section can provided along the outer surface. When the through-wall connector is installed in a pane, the external threaded section can be received through the aperture, the first connection interface can be positioned at a first side of the panel, and the second connection interface can be positioned at a second side of the panel opposite the first side. The radial protrusion can extend outwardly from the outer surface. A threaded nut can be sized to receive the threaded section. When the through-wall connector is installed in the panel, the threaded nut can threadably engage the external threaded section, the threaded nut can contact the first side of the panel, and the protrusion can contact the second side of the panel.

In some examples, the first connection interface includes a planar flange extending radially from the first distal end. In some examples the planar flange defines a first outer diameter, wherein the external threaded section defines a second outer diameter, wherein the second outer diameter is greater than the first outer diameter. In some examples the external threaded section defines a D-shaped cross-sectional profile. In some examples the through-wall connection, further includes a third connection interface defining a third opening, the third connection interface positioned between the first connection interface and the second connection interface, and the third opening in fluid communication with the interior channel. In some examples, the radial protrusion comprises a flange that extends along a whole circumference of the body. In some examples, the body is formed from an injection-molded plastic. In some examples, an engagement between the radial protrusion and the panel provides at least an IP65 seal against the entry of dust and liquids through the aperture. In some examples, an O-ring is provided between the radial protrusion and the panel.

Some examples of the present disclosure can provide a method of providing a liquid entry into an enclosure. The method can include providing a through-wall connector. The through-wall connector can include a tubular body, a first connection interface, a second connection interface, a raised threaded section, and a stopping flange. The tubular body can include an exterior wall having a first wall thickness, the tubular body defining a first distal end, a second distal end, and an interior channel. The first connection interface can be positioned at the first distal end and can have a first opening. The second connection interface can be positioned at the second distal end and can have a second opening. The interior channel can be defined between the first opening and the second opening. The raised threaded section can be provided at an exterior of the tubular body, the raised threaded section defining a second thickness that is greater than the first wall thickness. The stopping flange can extend radially outward from the tubular body. A panel can be provided including a panel aperture, a first surface on a first side of the panel, and a second surface on a second side of the panel. The through-wall connector can be inserted through the panel aperture, wherein, when the through-wall connector is inserted into the panel aperture, the raised threaded section extends through the panel aperture, and the stopping flange contacts the second surface of the panel. A threaded nut can be secured onto the threaded section to secure the through-wall connector to the panel, wherein, when the threaded nut is secured to the threaded section, a surface of the threaded nut contacts the first surface of the panel.

In some examples, both of the first connection interface and the second connection interface comprise radial flanges. In some examples, the radial flanges define a flange diameter, and the raised threaded section defines a threaded section diameter, wherein the threaded section diameter is greater than the flange diameter. In some examples, the panel aperture is a D-shaped aperture, and the threaded section includes a flat portion to engage the D-shaped aperture to at least partially limit a rotation of the through-wall connector relative to the panel. In some examples, the through-wall connector is formed from an injection-molded plastic. In some examples, the through-wall connector further includes a third connection interface including a third opening, the third connection interface positioned between the first and second connection interfaces, the third opening being in communication with the interior channel.

Some examples of the present disclosure provide a liquid entry system. The liquid entry system can include an enclosure, a through-wall connector, and a threaded nut. The enclosure can include a panel defining a first side disposed within the enclosure, and a second side positioned external to the enclosure, the panel having a panel aperture. The through-wall connector can be configured to be installed within the panel. The through-wall connector can include a tubular body, an outer threaded section, and a stopping flange. The tubular body can define an interior channel and an outer surface, the outer surface defining a first diameter. The outer threaded section can define a second diameter, the threaded section extending outwardly from the outer surface, and the second diameter being greater than the first diameter. When the through-wall connector is installed in the panel, the outer threaded section can extend through the panel aperture. The stopping flange can extend radially along a circumference of the tubular body, the stopping flange being adjacent to the outer threaded section, the stopping flange contacting the second side of the panel when the through-wall connector is installed within the panel. When the through-wall connector is installed within the panel, the threaded nut can threadably engage the threaded section and the threaded nut can contacts the first side of the panel.

In some examples, the engagement of the stopping flange and the panel provides at least an IP65 seal against the entry of dust and liquids into the enclosure. In some examples, the panel aperture is a D-shaped aperture, wherein the threaded section includes a flat portion to engage the D-shaped aperture to at least partially limit a rotation of the through-wall connector relative to the panel. In some examples, the tubular body includes a first connection interface at a first distal end and a second connection interface at a second distal end, wherein each of the first and second connection interfaces include tri-clamp fittings. In some examples, the liquid entry system further includes an O-ring between at least one of the threaded nut and the panel and the stopping flange and the panel.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the connectors or systems described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the disclosure and, together with the description, serve to explain the principles of embodiments of the disclosure:
FIG. 1 is a top, front, right view of a system for cooling a battery bank according to some aspects of the disclosure;
FIG. 2 is an exploded top, front, right isometric view of a through-wall connector, according to some aspects of the disclosure;
FIG. 3 is a cross-sectional view of a liquid entry system in an enclosure, including the through-wall connector of FIG. 2;
FIG. 4 is a top, right side view of the liquid entry system of FIG. 3. with paneling of the enclosure removed;
FIG. 5 is a top, front, left isometric view of parallel through-wall connectors;
FIG. 6 is a top, front, right partial view of a liquid entry system including parallel through-wall connectors of FIG. 5; and
FIG. 7 is a top, rear, right partial view of the liquid entry system of FIG. 6.

### DETAILED DESCRIPTION

Before any embodiments of the disclosure are explained in detail, it is to be understood that the disclosure is not limited in its application to the details of construction and the arrangement of components set forth in the following description or illustrated in the following drawings. The disclosure is capable of other embodiments and of being practiced or of being carried out in various ways.

The following discussion is presented to enable a person skilled in the art to make and use embodiments of the disclosure. Various modifications to the illustrated embodiments will be readily apparent to those skilled in the art, and the generic principles herein can be applied to other embodiments and applications without departing from embodiments of the disclosure. Thus, embodiments of the disclosure are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the disclosure. Skilled artisans will recognize the examples provided herein have many useful alternatives and fall within the scope of embodiments of the disclosure.

Electrical equipment housed within enclosures (e.g., energy storage systems) can generate heat in operation, and can often require cooling systems to transfer heat away from the equipment. Increasingly, liquid cooling systems can be provided to cool electrical equipment, including electrical equipment housed within enclosures. Notably, for a given volume, water has approximately a 3,500 times higher heat capacity than air. As a result, liquid cooling systems can absorb a large amount of thermal energy before its own temperature rises significantly, thereby maintaining a larger temperature gradient between itself and the equipment that thus sustains a cooler temperature overall. In this way, liquid cooling can provide increased cooling capacity over some conventional cooling methods (e.g., such as air) and can be particularly adapted for electrical equipment generating large amounts of heat due to a density or quantity of electrical equipment in an enclosure.

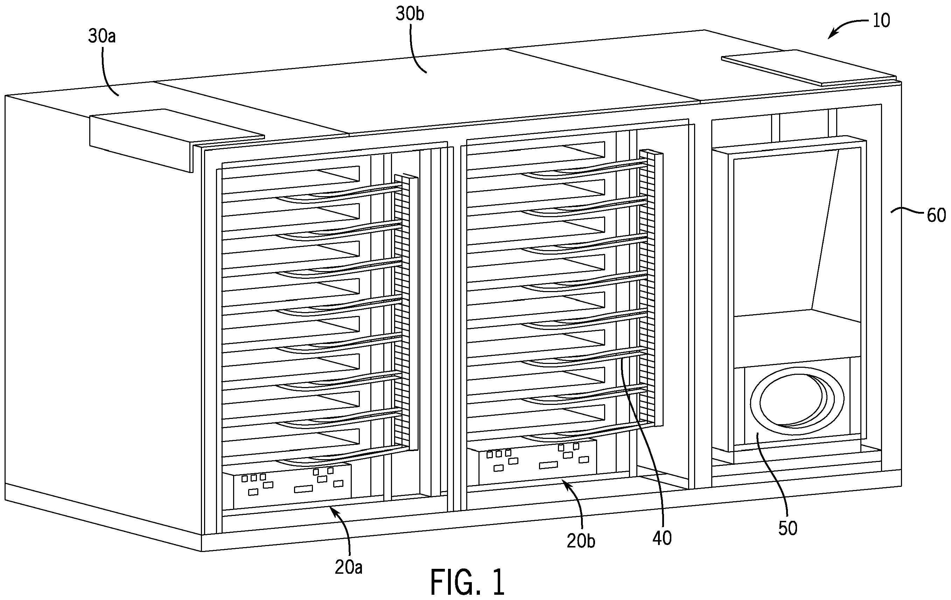

FIG. 1 illustrates a liquid cooling system 10 for energy storage systems 20a, 20b (e.g., battery energy storage systems, battery cells and modules, power conversion systems, etc.) housed in enclosures 30a, 30b respectively. As shown, the system 10 includes liquid cooling lines 40 through which a liquid coolant flows to cool electronic components (e.g., batteries, battery cells, etc.). The liquid cooling lines 40 further include inlets to individual portions of the energy storage systems 20a, 20b, and corresponding outlets from the individual portions. In this way, the liquid cooling lines 40 can define a closed loop for the energy storage systems 20a, 20b. For example, chilled coolant is provided to the electrical equipment of the energy storage systems 20a, 20b at the inlets and can flow through the electrical equipment. Heat from the electrical equipment can then be transferred to the coolant, and the heated coolant can flow out of the electrical equipment at the outlets to transfer heat away from the electrical equipment.

Cooling systems for energy storage systems (e.g., battery banks) can be housed in enclosures separate from the energy storage systems. As further shown in FIG. 1, for example, a chiller 50 is provided housed in an enclosure 60, distinct from enclosures 30a, 30b. The liquid coolant flowing through the lines 40 can be circulated through the chiller 50 to cool the fluid, and the cooled liquid coolant can be recirculated back into the enclosures 30a, 30b to cool the electrical equipment therein. The chiller 50 can cool fluid entering the enclosures 30a, 30b (e.g., the liquid coolant of the closed cooling loop) through any known means of cooling a fluid (e.g., through refrigeration cycles, liquid-to-liquid heat transfer, air-to-liquid heat transfer, etc.). In the illustrated example, the chiller 50 cools the fluid coolant through a flow of ambient air across a liquid-to-air heat exchanger. In some cases, fluid can be provided directly to the electrical equipment (e.g., the energy storage systems 20a, 20b) from a facility source that mitigates the need to provide a chiller to cool a fluid coolant prior to provision of the coolant to the electrical equipment.

In some cases, entry of fluid, dust, or contaminants into an enclosure housing electrical equipment (e.g., enclosures 30a, 30b) can degrade a performance of the electrical equipment. Enclosures housing electrical equipment can be fully or partially sealed against the entry of contaminants (e.g., particulate matter or liquid) to protect the electrical equipment. Enclosures and sealing systems for the enclosures an adhere to industry standards and regulations in that regard. For example, in some cases, enclosures can be rated to maintain an IP65 rated seal. In some examples, enclosures can be rated for other sealing standards, including, for example, ingress protection for solids and liquids (e.g., any of ingress protections IP01-IP69, including IP64, IP66, IP67, IP54, and other seal types that similarly protect the electrical equipment against entry of contaminants can be used).

It should be noted that while the enclosures 30a, 30b, and 60 are shown with the panels removed for clarity purposes of this disclosure, in use, the enclosures include panels to enclose the components in the respective enclosures. Furthermore, while each of the enclosure 30a, 30b, and 60 are shown with a panel having one side open to exposure, the enclosures 30a, 30b also have panels that are fully enclosed within the energy storage systems 20a, 20b. In other examples, the enclosures 30a, 30b, and 60 have panels that are open to exposure on more than one side.

Sealing an enclosure can include providing systems and elements for sealing an entry point into an enclosure. For example, enclosures can include openings for allowing the entry of wiring, and the openings can be sealed against entry of contaminants at the entry. In liquid cooling systems (e.g., the system 10 shown in FIG. 1) openings can be provided for enclosures housing electrical equipment to be cooled to allow a flow of fluid coolant into and out of the enclosure. In some cases, according to the present disclosure, openings can be provided in panels of an enclosure to allow piping of a liquid cooling system to extend through the panels into the enclosure. Sealing the enclosure, can necessitate sealing an entry point of one or more liquid cooling lines (e.g., liquid cooling lines 40) into an enclosure housing electrical equipment (e.g., enclosures 30a, 30b). For example, with continued reference to FIG. 1, the enclosure 60 housing the chiller 50 can have different sealing requirements than the enclosures 30a, 30b, as noted above. In particular, the enclosures 30a, 30b can be relatively enclosed and sealed in comparison to its environment (e.g., fully or partially sealed against the entry of dust, water, and contaminants, as noted above). In contrast, the enclosure 60 can be relatively open to allow a flow of air across a heat exchanger to effect a heat exchange from the liquid coolant in the fluid lines 40 to an ambient air. For example, the chiller 50 can include fans to blow an air from an environment across a heat exchanger to transfer heat away from the liquid coolant. Thus, the enclosure 60 can be relatively open to ambient air, and in some cases would not adhere to an IP65 sealing requirement for which the enclosures 30a, 30b are rated. It can therefore be necessary to provide liquid entry systems between enclosures housing electrical equipment (e.g., enclosures 30a, 30b shown in FIG. 1) and enclosures housing cooling equipment for a liquid coolant (e.g., enclosure 60 shown in FIG. 1). In this way, liquid entry cooling systems can maintain a seal of the enclosures 30a, 30b (e.g., an IP65 seal) at a connection point (e.g., in a wall or a panel of the enclosures 30a, 30b) between the enclosure 60 and the enclosures 30a, 30b.

In this regard, liquid entry systems can be provided for enclosures to provide a seal at a liquid entry point into an enclosure. Further, liquid entry cooling systems according to the present disclosure can have an improved performance over conventional liquid entry systems. For example, some liquid entry systems can include wetted threads (e.g., internal threads of the system along the fluid flow path) which can degrade over time due to a contact with fluid flowing through the systems, can be complicated to install, can have a high cost, and can be prone to leaks at an entry point of a liquid line into the enclosure. In other examples, some liquid entry systems can require purchase of expensive components (e.g., some solutions can require a combination of off-the-shelf components with a cost greater than $100).

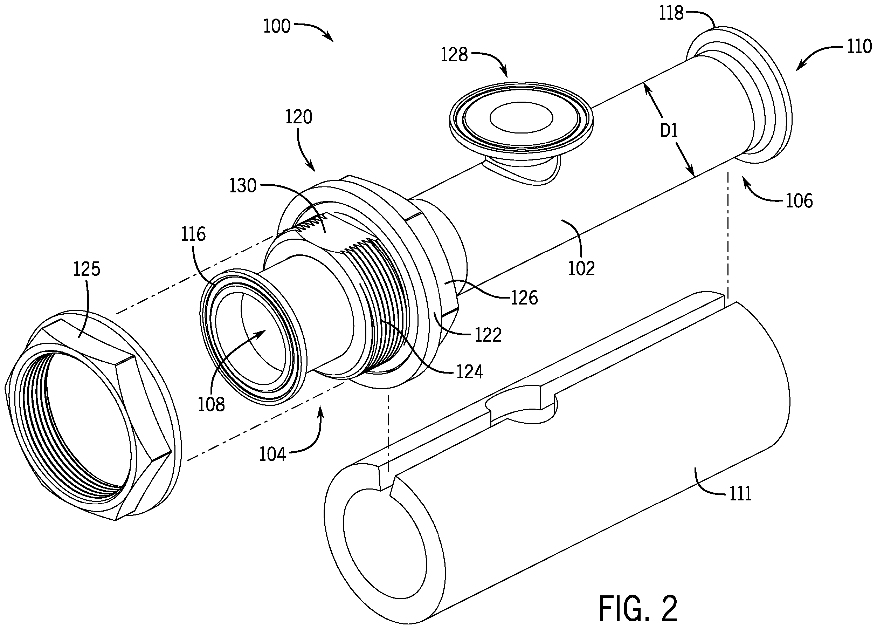

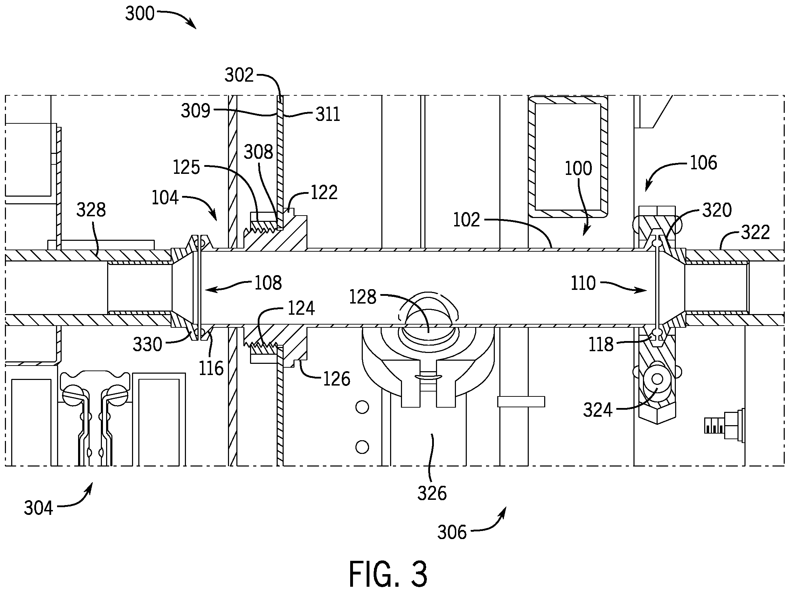

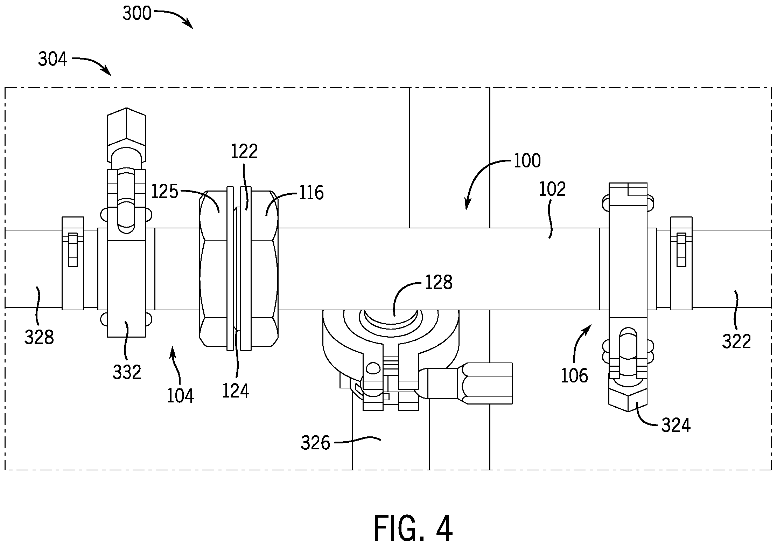

Liquid entry systems according to the present disclosure can address these and other problems by providing a relatively simple, inexpensive, and leak-proof seal between the enclosure 60 and the enclosures 30a, 30b. For instance, FIG. 2 illustrates an example through-wall connector 100 for use in a liquid entry system (e.g., the liquid entry systems 200 shown in FIGS. 3 and 4). As shown, the through-wall connector 100 includes a tubular body 102 extending between a first distal end 104 and a second distal end 106. Through-wall connectors can include connection interfaces to allow for connection of hosing and piping with the through-wall connector. A connection interface can include fittings and components to allow for integration with fluid connection systems. For example, a connection interface can include a tri-clamp fitting (e.g., a flange compatible with a tri-clamp connection system), quick-disconnect ports, or other port types that can integrate with known systems or standards for fluid connections. In the illustrated example, a first opening 108 is defined in the first distal end 104, and a second opening 110 is defined in the second distal end 106. The first and second openings 108, 110 can be openings provided in respective connection interfaces to allow the flow of a fluid through the through-wall connector 100. In this way, the tubular body 102 defines a channel between the first opening 108 and the second opening 110, the channel configured to allow the flow of fluid (e.g., water, a coolant) through the tubular body 102 between the first opening 108 and the second opening 110. In the illustrated example, the tubular body 102 has a sheath 111 that substantially surrounds a portion of the tubular body 102. The sheath 111 can be made of a thermoplastic material (e.g., polyvinyl chloride (PVC), polyethylene (PE), etc.) and defines an exterior surface, having a first diameter D1 along the exterior surface of the tubular body 102 (i.e., an outer diameter). In this way, the sheath 111 acts as a protective encasing of the tubular body 102 that protects the tubular body 102 and corresponding channel from outside contaminants such as dust and debris. As such, the sheath 111 can thereby prolong the overall lifespan of the connector 100. In some cases, the sheath 111 can provide insulation for the connector 100, or can mitigate potential condensation on the tubular body 102 of the connector 100. Furthermore, the sheath 111 can include a longitudinal slit extending along an entire length of the sheath 111. The slit can facilitate an installation of the sheath 111 onto the connector 100 and a removal therefrom for servicing (e.g., inspect, repair, clean). In some cases, the body of the through-wall connector 100 can be formed from steel. In some cases, the body of a through-wall connector can be an injection-molded plastic.

In some cases, liquid entry cooling systems according to the present disclosure can include one or more through-wall connectors having flanges configured to interface with tri-clamp fitting connections. For example, the through-wall connector 100 further includes flanges 116, 118 extending outwardly along a circumference of the tubular body 102 at the first and second distal ends 104, 106, respectively. As noted above, the flanges 116, 118 are sized and configured to be compatible with a tri-clamp fitting to facilitate a sealed connection between the through-wall connector 100 and plumbing elements (e.g., piping or tubing) upstream and downstream of the through-wall connector 100. In some cases, the channel of the through-wall connector 100 allow the through-wall connector 100 to be usable with piping and hosing having standard diameters. For example, the channel can have about a 1-inch diameter, about a 2 inch diameter, or about a 3 inch diameter. In some examples, the through-wall connectors 100 are provided for any standard size of piping or hosing.

Through-wall connectors of the present disclosure can include features for mounting and securing the through-wall connecter to a wall or a panel. For example, as further shown in FIG. 2, the through-wall connector 100 includes a mounting structure 120 extending radially outward from the exterior surface of the tubular body 102 at the first distal end 104. As illustrated, the mounting structure 120 defines a diameter that is greater than diameter Dl.

A through-wall connector can include structures and geometries that can ensure a desired location and orientation of the connecter relative to a panel of an enclosure. For example, as illustrated, the mounting structure 120 includes a stopping flange 122 and a threaded section 124. In some cases, a mounting structure for a through wall connector can comprise a sheath that can receive a tubular body of the through-wall connector (e.g., through a concentric channel in the mounting structure). In some cases, a mounting structure can be of unitary construction with the tubular body of a through-wall connector.

In the illustrated embodiment, the stopping flange 122 includes a planar face that is substantially perpendicular to a direction of flow between the first opening 108 and the second opening 110. During use, the stopping flange 122 contacts a corresponding planar surface of a panel of an enclosure when the through-wall connector 100 is mounted within the panel. In this way, the stopping flange 122 can contact the panel when the threaded section 124 extends through an aperture of the panel, and functions as a stopping feature, at least partially defining a position and configuration of the through-wall connector 100 relative to the panel. A position of the stopping flange can determine a depth to which a connector extends into an enclosure (e.g., a length of the connector extending from a panel into an enclosure, and a length of the connector extending in an opposite direction from the panel to outside of the enclosure). In the illustrated example, the stopping flange 120 is located closer to the distal end 104 than the distal end 106. In some examples, a stopping flange can be centrally positioned along a tubular body of a through-wall connector. Further, in the illustrated embodiment, the stopping flange 111 comprises a circular disc extending along an entire circumference of the tubular body 102. In other examples, a stopping flange can extend along a portion of the circumference of a tubular body (e.g., the stopping flange can be a half-disk, can comprise multiple semi-circular disc portions spaced apart along a circumference of the tubular body). In other examples, a stopping flange can comprise any protrusion from the tubular body that can constrain a depth of insertion of a through-wall connector into an enclosure (e.g., through contact with a panel of the enclosure).

Returning to FIG. 2, as noted above, the threaded section 124 can extend in the longitudinal direction of the tubular body (e.g., the threaded section 124 can define a length in a direction parallel to a flow direction between the openings 108 and 110). The threaded section 124 can define a diameter that can allow the threaded section 124 to extend through a corresponding aperture in a panel or wall. In some cases, as described further below, the threaded section 124 can define a cross-sectional profile with a shape that correspond to the shape of a hole in a panel through which the threaded portion is received (e.g., a flat surface 130 can be provided on the threaded section 124 to correspond to a "D"-shaped aperture in a panel). Further, in the illustrated example, a diameter of the threaded section 124 is greater than a maximum diameter of the flange 116 as can advantageously allow a nut 125 to be inserted onto the through-wall connector 100 and threadably engage the threaded section 124. As shown, the threaded section 124 is an external threaded section, and includes threads along an exterior thereof (i.e., on an opposite side of the exterior surface from the channel, extending radially outwardly relative to the tubular body 102). The threads of the threaded section 124 are therefore not in contact with a fluid when the fluid flows through the through-wall connector. This advantageously reduces (e.g., eliminates) a need to seal the threads to prevent corrosion or leakage at the threaded section 124 thereby simplifying the installation and the manufacturing processes. The threads along the exterior surface may also visually indicate to an installer how far the nut 125 is fastened onto the threaded section 124 during installation, and correspondingly, how secure the connector 100 is within the panel.

As previously mentioned, the threaded section 124 engages a corresponding nut 125 that can be threadably secured to the threaded section 124 on an opposite side of a panel from the stopping flange 122. In this way, the nut 125 in concert with the stopping flange 122, secures the through-wall connector 100 to the panel. In some cases, sealing members (e.g., O-rings) can be provided between one or both of a nut (e.g., nut 125) and a panel, and between a stopping flange (e.g., stopping flange 122) and the panel to provide additional protection against entry of dust or fluid into an enclosure. Installing the through-wall connector 100 can include inserting the connector 100, including the threaded section through an aperture of a panel until the stopping flange 122 contacts the panel, and inserting the nut 125 onto the through-wall connector to threadably engage the threads of the threaded section 124.

In some cases, through-wall connectors, according to the present disclosure, can include features to allow for a tightening of a nut onto the through-wall connector (e.g., to oppose a rotation of the through-wall connector when the nut 125 is being secured thereupon). As further shown in FIG. 2, the mounting structure 120 includes a hexagonal engagement portion 126 that facilitates an engagement of tools (e.g., wrenches, pliers, etc.) with the through-wall connector 100 to perform a tightening or loosening operation. In some cases, the through-wall connecter 100 does not include a hexagonal engagement portion. In some cases, the hexagonal engagement portion 126 and the stopping flange 122 are integral with a through-wall connector 100. In other examples, the hexagonal engagement portion 126 and stopping flange 122 are elements of a nut threadably engaged with the threaded portion, the nut being positioned and configured to be on an opposite side of a panel from an opposing nut also received on the threaded portion. For example, in some cases, a through-wall connector does not include a stopping flange, and a threaded section can extend on both sides of an aperture within a panel when the through-wall connecter is received into the panel aperture. When the through-wall connecter is in place, nuts (e.g., similar to nut 125) can be installed on both sides of a panel and the respective nuts can engage opposing sides of the panel.

In some cases, through-wall connectors (e.g., through-wall connector 100) can facilitate different flow patterns within an enclosure. For example, a through-wall connecter can include multiple openings (e.g., ports) with accompanying flanges to provide multiple ports to which piping or hosing can be connected with tri-clamp fittings. As further shown in FIG. 2, the through-wall connector 100 also includes an additional port 128 arranged at a "tee" (e.g., at a right angle) relative to the tubular body 102 between the first distal end 104 and the second distal end 106. The additional port 128 engages a tri-clamp fitting (e.g., can include a flange) and facilitates a flow of fluid in a direction that is perpendicular to a flow between the first opening 108 and the second opening 110. Favorably, as noted above, because the connector 100 can be easily installed and removed with the panel, a user can more accurately rotatably configure the port 128 in the desired position of fluid flow.

In some examples, the ports of a through-wall connector can be differently arranged. For example, a through wall connecter can include multiple ports arranged at a "tee" relative to a body of a through-wall connectors. Ports of a through-wall connecter, in some examples, can extend from the through-wall connecter at oblique angles relative to a through-wall connecter. In some examples, a through-wall connecter includes only a first and second opening, and no additional ports are provided. Other configurations are possible, however, and a through-wall connecter can include any number of ports arranged at any desired angle relative to a first opening.

In some cases, as previously discussed, it can be useful to enforce an orientation of a through-wall connecter within a panel. For example, some applications require a specific positioning and orientation of the ports of a through-wall connector to more easily engage plumbing elements within a given enclosure. In some cases, features are provided for a through-wall connector to prevent a rotation of the through-wall connector and ensure a desired position of elements (e.g., ports or openings) of the through-wall connector within an enclosure. Referring still to FIG. 2, the threaded section 124 further includes a flat portion 130 that is devoid of threading. In this way, a cross-sectional profile of the threaded section 124 therefore defines a "D" (e.g., a generally circular shape with a flat edge on one side). The flat portion 130 allows an insertion of the threaded section 124 into a correspondingly D-shaped aperture in a panel. Engagement of the flat portion 130 with the corresponding D-shaped aperture enforces an angular orientation of the port 128 within an enclosure when the through-wall connector is installed in the panel. The flat portion 130 further opposes (e.g., prevents or limits) rotation of the through-wall connector 100 when the nut 125 is tightened on the threaded section 124 of the through-wall connector 100. Notably, this eliminates the need for a user to hold the body 102 of the through-wall connector 100 with a tool (e.g., a wrench) during installation thereby simplifying the installation process and greatly reducing installation time.

In some cases, a threaded portion of a through-wall connector does not include a flat portion. In some cases, a threaded portion of a through-wall connecter can define any cross-sectional profile to matably engage a corresponding profile within a panel to enforce an orientation of the through-wall connector relative to the panel. In some cases, a threaded section of a through-wall connector can include multiple flat portions to allow the connector to be installed in one of a plurality of predefined angular orientations. For example, a threaded section can have symmetrical flat sections on opposite sides of the threaded section, to allow the connector to be inserted into a panel of an enclosure in either of a first orientation, or a second orientation, the second orientation being an orientation in which the connector is rotated 180 degrees relative to the first rotation. According to some aspects of the disclosure, a threaded section can include any number of flat portions to allow the connector to be installed in any number of predetermined orientations.

FIG. 3 illustrates a liquid entry system 300 that includes the through-wall connector 100 secured to a panel 302 to allow a flow of fluid from a first space 304 into an enclosure 306. As illustrated, the panel 302 includes a panel aperture 308 sized and configured to receive the threaded section 124 of the mounting structure 120. In the example shown, the threaded section 124 extends through the panel aperture 308, and the stopping flange 122 engages a first side 309 of the panel 302 to limit an insertion depth of the through-wall connector 100 through the panel 302.

As further shown in FIG. 3, the nut 125 is threadably engaged with and tightened onto the threaded section 124 to secure the through-wall connector 100 to the panel 302. In particular, the nut 125 engages a second side 311 of the panel 302, opposite the first side 309. This engagement, in concert with the stopping flange 122, ensures that the through-wall connector 100 is secured to the panel 302. In this way, the nut 125 and the stopping flange 122 can at least partially seal the panel aperture 308 against entry of dust, contaminants, or fluids through the panel aperture 308. For example, the stopping flange 122 and the nut 125 both extend radially along an entire circumference of the aperture 308 that provides a seal along the whole circumference. In the illustrated example, the liquid entry system 300 (e.g., the engagement of the through-wall connector 100, the nut 125, and the panel 302) achieves an IP65 rated seal. In other examples, the liquid entry system 300 can provide a greater or less protection against the entry of dust or fluids through the panel aperture 308 (e.g., fluids not flowing through a through-wall connector installed in the panel aperture). For example, sealing elements can be provided between an interface between the stopping flange 122 and the panel 302, or between the nut 125 and the panel 302. In some examples, the sealing element can include one or more O-rings provided at an interface between a stopping flange 122 or the nut 125 and the panel 302 to further seal the panel aperture 308 against entry of liquids through the aperture 302 into the enclosure 306.

As shown in FIG. 3, an exterior wall of the tubular body 102 can define a first thickness and a first outer diameter. The first diameter of the outer surface of the exterior wall can be a diameter of the tubular body along a majority of the length of the tubular body 102. As shown, the threaded section can have a second diameter that is greater than the first diameter (e.g., the threaded portion can have a greater thickness than a thickness of the exterior wall of the tubular body 102). Further, as shown, the stopping flange 122 defines a third circumference that is greater than each of the tubular body (e.g., D1) and the threaded section (e.g., the second diameter). The second diameter of the threaded section 124 can be configured to allow insertion of the threaded portion through the panel aperture 308. The panel aperture 308 can be larger than the second diameter of the threaded section as can allow the threaded section 124 to be inserted through the panel aperture 308. Further, the flange 116 can define a flange diameter that is smaller than the panel aperture 308 as can allow insertion of the flange through the aperture 108. The second diameter of the threaded section 124 can be greater than a diameter of the flange 116.

As further shown in FIG. 3, ports of the through-wall connector 100 can be fluidly connected with plumbing elements within an enclosure. For example, as illustrated, the flange 118 on the second distal end 106 can be aligned with a corresponding flange 320 of a hosing 322 within the enclosure 306. The flanges 118, 320 are secured in a clamp 324 (e.g., the through-wall connector 100 is connected to the hosing 322 via a tri-clamp fitting) that can at least partially seal the interface between the hosing 322 and the through-wall connector 100 against a leakage of fluid at the interface. Similarly, the port 128 is shown connected to an additional hosing 326 via a tri-clamp connection. In the illustrated example, each of the openings 108, 110, 128 are provided with a tri-clamp interface to allow respective clamps to connect compatible fittings of hosing to be connected to the connector 100. In other examples, ports (e.g., openings) for a through-wall connector can comprise other connection interfaces. For example, a through-wall connector can include quick-disconnect fittings at ports thereof (e.g., male or female connection interfaces). In some cases, a through-wall connector can include a port of a first type (e.g., a tri-clamp fitting) on a first side, and a port of a second type (e.g., a quick-disconnect fitting) on a second side of a panel to allow for use in applications where different connection types are used in different enclosures.

Returning to FIG. 3, in the illustrated embodiment, when the hosing 322 and the through-wall connector 100 are connected, the second opening 110 is in fluid communication with an interior channel of the hosing 322 to allow fluid to flow between the through-wall connector 100 and the hosing 322. Similarly, the first opening 108 at the first end 104 is in fluid communication with a hosing 328 within the first space 304 that allows fluid from the first space 304 to flow through the through-wall connector 100 into plumbing elements (e.g., hosing 322, 326) within the enclosure 306. As further illustrated, the flange 116 is aligned with a corresponding flange 330 of the hosing 328 to provide a seal therebetween. In this example, a tri-clamp secures the flanges 116, 330 together.

As illustrated from the perspective shown, the port 128 can be positioned facing generally downward (e.g., in a direction of gravity) and away from the viewer and accommodates a configuration of piping within the enclosure 306. In other configurations, the port 128 is oriented at any angle and can accommodate a variety of configurations of piping or hosing within the enclosure 306. In some examples, the through-wall connector 100 only includes the first opening 108 and the second opening 110 and does not include additional ports. In other examples, the port 128 can be positioned anywhere along the tubular body 102, such as being located closer to the first opening 108 than the second opening 110. In some embodiments, the port 128 is positioned closer to the second opening 110 than the first opening 108. In some examples, one of the port 128 and second opening 110 can be sealed (e.g., with a cap sealing the opening) to prevent a flow of fluid therethrough.

FIG. 4 illustrates the liquid entry system 300, as described in FIG. 3, with the structure of the enclosure 306 and the first space 304 removed to show only the plumbing elements (e.g., the piping and hosing 322, 326, 328 and the through-wall connector 100). In the example of FIG. 4, the hosing 328 is further secured to the through-wall connector 100 with a tri-clamp 332. Favorably, using a tri-clamp to secure the hosing 322, 326, 328 to the connector 100 allows for a quick installation and removal of the connector 100, creates a leak-proof seal, is modular and flexible, and is compatible with hosing and other plumbing elements of varying shapes and sizes.

Referring still to FIG. 4, the threaded section 124 between the nut 125 and the stopping flange 122 substantially matches the size (e.g., thickness) of the panel 302 of FIG. 3. In this way, the nut 125 is not fully fastened onto the threaded section 124 when installed and allows the connector 100 to be installed within a variety of different panel 302 sizes and thicknesses.

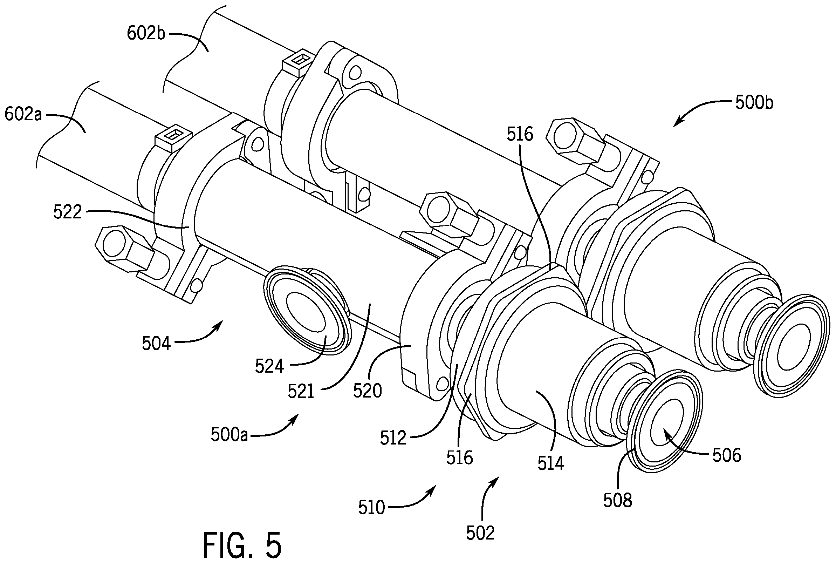

In the examples described above with respect to FIGS. 2-4, the through-wall connector 100 is of unitary construction, with all portions of the connector 100 being integrally formed with the through-wall connector 100. In other examples, including as shown in FIGS. 5-7 and will be further discussed below, a through-wall connector 500 can be of multi-part construction.

FIG. 5 illustrates parallel through-wall connectors 500a, 500b, connected to tubing 602a, 602b. Through-wall connectors 500a, 500b can be similar (e.g., identical) with one comprising a liquid inlet into an enclosure, and the other comprising a liquid outlet from the enclosure. In some cases, as shown below, ports 524 of through-wall connectors 500a, 500b can be disposed at different angles relative to one another. However, while the following description is provided for through-wall connector 500a, the description applies equally to through-wall connector 500b. It should also be noted that the through-wall connectors 500a, 500b employ similar benefits as discussed above with respect to the through-wall connector 100.

As shown, the through-wall connector 500a includes a first tubular body 502. In the illustrated example, the first tubular body 502 includes a first opening 506 with a corresponding flange 508, configured to integrate with a tri-clamp fitting on a first side of a panel, external to an enclosure (e.g., as similarly discussed above with respect to FIGS. 2-4). The first tubular body 502 further includes a mounting portion 510 configured to engage the panel of the enclosure to retain the through-wall connector 500a relative to the panel. In this way, the mounting portion 510 also at least partially seals an aperture in the panel against the entry of dust, fluid, and other contaminants.

The mounting portion 510 includes a threaded portion (not shown), and a stopping flange 512. The stopping flange 512 is similar to stopping flange 122 shown and described in FIGS. 2-4 and can similarly operate to limit an insertion distance of the first tubular body 502 through an aperture of a panel, as well as seal the aperture of the panel.

The through-wall connector 502a further includes a sleeve 514 including a hexagonal engagement portion 516. The sleeve 514 includes an internal threaded portion (not shown) sized and configured to receive the threaded portion of the mounting portion 510. The sleeve 514 can perform a similar function to the nut 125 shown and described with respect to FIGS. 2-4. For example, the sleeve 514 is secured onto the first tubular body 502 from an exterior side of an enclosure (e.g., on an opposite side of a panel from the stopping flange 512). A surface of the sleeve 514 contacts the first side of the panel to at least partially seal an aperture of the panel against the entry of dust or liquids. In some cases, the hexagonal portion 516 can be configured to be engaged by tools (e.g., wrenches, pliers, etc.) to allow tightening or loosening of the sleeve 514 relative to the first tubular body 502.

As further shown, the first tubular body 502 is secured to a second tubular body 504 via a tri-clamp fitting 520 (e.g., a flange and an opening of the first tubular body 502 are aligned with a corresponding flange and opening of the second tubular body 504 to allow fluid communication therebetween, and a tri-clamp secures the respective flanges of the first and second tubular bods 502, 504 together to provide a seal at the interface between the first and second tubular bods 502, 504). The tri-clamp fitting 520 is thus configured to be positioned within an enclosure, on an opposite side of a panel from the sleeve 514 and the first opening 506.

The second tubular body 504 includes a sheath 521 that encloses the second tubular body 504 and defines an exterior surface. The sheath 521 extends between the stopping flange 512 and an opening (not shown) at a tri-clamp fitting 522. In this way, the second tubular body 504 also defines a channel between an opening at the tri-clamp fitting 520 and the opening at the tri-clamp fitting 522. The tri-clamp fitting 522 can be substantially identical to tri-clamp fitting 520. In this way, the tri-clamp fitting 522 provides a seal at an interface of the second tubular body 504 and the hosing 602a. As shown, therefore, the engagement of the first tubular body 502, second tubular body 504, and the respective tri-clamp fittings 520, 522 provide fluid communication between the first opening 506 (e.g., an opening configured to be positioned external to an enclosure) and the hosing 602a (e.g., hosing configured to be within the enclosure).

In the illustrated example, the second tubular body 504 further includes a port 524 configured to integrate with a tri-clamp fitting (e.g., similar to port 128). The port 524 can be positioned at any desired angular position to engage with corresponding hosing or piping within the enclosure. In some cases, the second tubular body 504 does not include an additional port. In other examples, the second tubular body 504 can include any number of ports, including more than one, or more than two ports. In some cases, a cap can be provided for the port 524 of the second tubular body 504 to prevent flow of fluid through the port 524 when the port 524 is not in use. In some examples, the through-wall connector 502a, 502b does not include a second tubular body 504, and the hosing within the enclosure can engage the first tubular body 502 directly (e.g., at tri-clamp fitting 520).

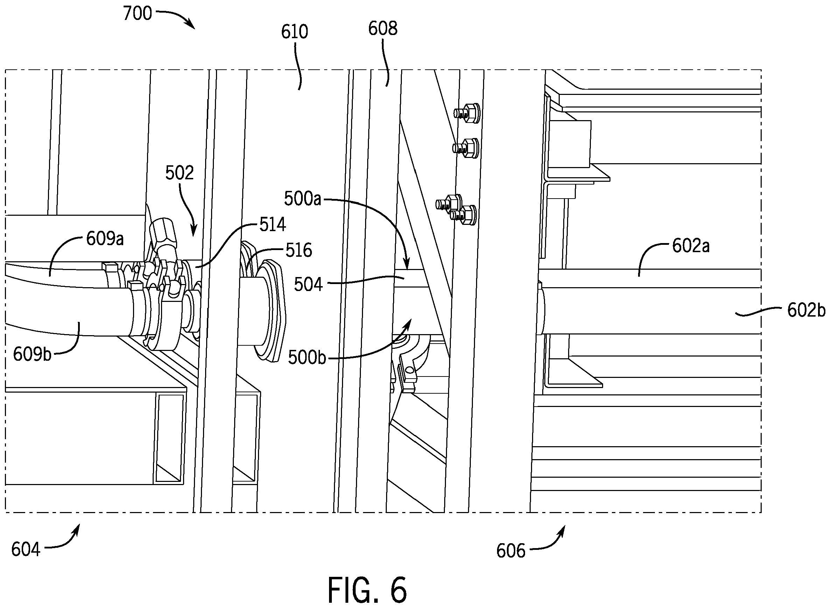

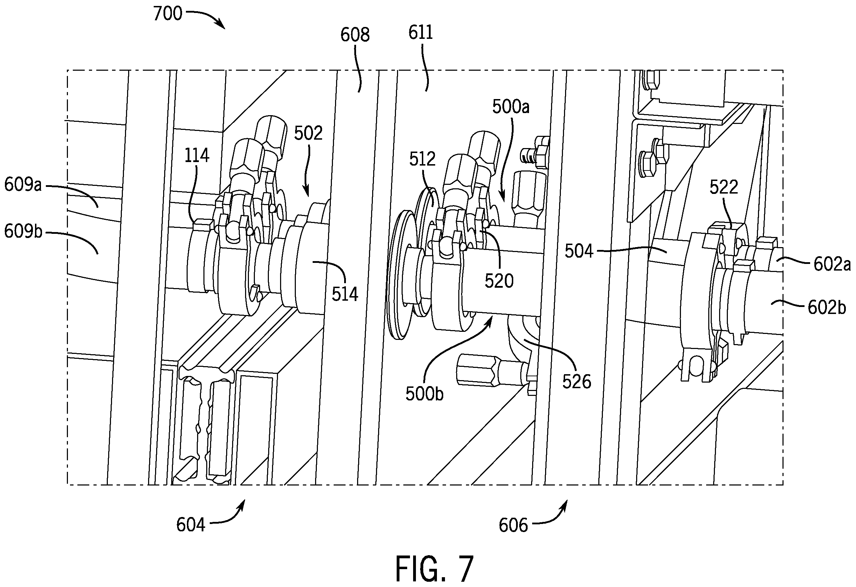

FIGS. 6 and 7 illustrate a fluid entry system 700 including the through-wall connectors 500a, 500b. As shown, the fluid entry system 700 facilitates a flow of fluid between a first space 604 and an enclosure 606. Furthermore, the through-wall connectors 500a, 500b, the first space 604 and the enclosure 606 are separated by a panel 608. As illustrated, the through-wall connectors 500a, 500b are fluidly connected (e.g., with a tri-clamp fitting at first the opening 506 of the connector 500a, 500b) to hosing 609a, 609b on a first side 610 of the panel 608, within the first space 604. In particular, the first tubular body 502 is received within an aperture of the panel 608, and the sleeve 514 is received onto the first tubular body 502 (e.g., is threadably engaged with the first tubular body 502).A surface of the sleeve 514 (e.g., a planar surface of the hexagonal portion 516) is in contact with the panel 608 to at least partially seal an interface between the sleeve 514 and the aperture within the panel 608.

As better shown in FIG. 7, the stopping flange 512 contacts a surface of the panel 608 on a second side 611 of the panel 608 interior to the enclosure 606. The engagement between the planar surface of the hexagonal portion 516, the panel 608, and the stopping flange 512 can thus secure the first tubular body 502 relative to the panel 608 and seal the aperture of the panel 608 against entry of dust or liquid at the interface between the first tubular body 502 and the panel 608.

As further shown, the tri-clamp fitting 520 and the second tubular body 504 are positioned within the enclosure 606, and at least partially fluidly connect the hosing 609a, 609b exterior to the enclosure 606 to the hosing 602a, 602b within the enclosure 606. Sealing between the hosing 602a, 602b, 609a, 609b and the connectors 500a, 500b is achieved with tri-clamp fitting 520 connecting the first tubular body 502 to the second tubular body 504, and tri-clamp fitting 522 securing the second tubular body 504 to the hosing 602a, 602b. Similarly, a tri-clamp fitting 526 is also used to secure the port 524.

Thus, liquid entry systems according to the present disclosure provide a relatively simple, inexpensive, and leak-proof seal between enclosures housing electrical equipment and enclosures housing cooling equipment. As discussed, a unitary or multi-part through-wall connector may be employed to achieve this connection that can greatly increase accuracy of fluid flow connection, reduce manufacturing costs, labor costs, and installation time, and furthermore employ an easy process in which a user may service the connector.

It will be appreciated by those skilled in the art that the disclosure is not limited to the examples described above in connection with particular configurations. Other embodiments, examples, uses, modifications and departures from the embodiments, examples and uses are intended to be encompassed by the claims attached hereto. The entire disclosure of each patent and publication cited herein is incorporated by reference, as if each such patent or publication were individually incorporated by reference herein. Various features and advantages of the disclosure are set forth in the following claims.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the connectors and systems described may be incorporated into/used in a corresponding method and vice versa.

It is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of' (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Also as used herein, unless otherwise limited or defined, "integral" and derivatives thereof (e.g., "integrally") describe elements that are manufactured as a single piece without fasteners, adhesive, or the like to secure separate components together. For example, an element stamped or cast as a single-piece component from a single piece of sheet metal or a single mold etc., without rivets, screws, or adhesive to hold separately formed pieces together, is an integral (and integrally formed) element. In contrast, an element formed from multiple pieces that are separately formed initially, then later connected together, is not an integral (or integrally formed) element.

## Claims

1. A through-wall connector comprising:
a body defining an outer surface, a first distal end, a second distal end, and an interior channel;
a first connection interface at the first distal end, the first connection interface defining a first opening;
a second connection interface at the second distal end, the second connection interface defining a second opening, the interior channel being defined between the first opening and the second opening;
an external threaded section provided along the outer surface, the external threaded section being received through the aperture, the first connection interface being positioned at a first side of the panel, and the second connection interface being positioned at a second side of the panel opposite the first side when the through-wall connector is installed in the panel;
a radial protrusion extending outwardly from the outer surface; and
a threaded nut sized to receive the threaded section, wherein when the through-wall connector is installed in the panel, the threaded nut threadably engages the external threaded section, the threaded nut contacts the first side of the panel, and the protrusion contacts the second side of the panel.

2. The through-wall connector of claim 1, wherein the first connection interface includes a planar flange extending radially from the first distal end.

3. The through-wall connector of claim 2, wherein the planar flange defines a first outer diameter, wherein the external threaded section defines a second outer diameter, wherein the second outer diameter is greater than the first outer diameter.

4. The through-wall connector of claim 1 or of claim 2 or claim 3, wherein the external threaded section defines a D-shaped cross-sectional profile.

5. The through-wall connector of claim 1 or of any of claims 2 to 4, further comprising a third connection interface defining a third opening, the third connection interface positioned between the first connection interface and the second connection interface, and the third opening in fluid communication with the interior channel.

6. The through-wall connector of claim 1 or of any of claims 2 to 5, wherein the radial protrusion comprises a flange that extends along a whole circumference of the body.

7. The through-wall connector of claim 1 or of any of claims 2 to 6, wherein the body is formed from an injection-molded plastic.

8. The through-wall connector of claim 1 or of any of claims 2 to 7, wherein an engagement between the radial protrusion and the panel provides at least an IP65 seal against the entry of dust and liquids through the aperture.

9. The through-wall connector of claim 8, wherein an O-ring is provided between the radial protrusion and the panel.

10. A method of providing a liquid entry into an enclosure, the method including:
providing a through-wall connector including:
a tubular body including an exterior wall having a first wall thickness, the tubular body defining a first distal end, a second distal end, and an interior channel,
a first connection interface at the first distal end and having a first opening,
a second connection interface at the second distal end and having a second opening, wherein the interior channel is defined between the first opening and the second opening,
a raised threaded section provided at an exterior of the tubular body, the raised threaded section defining a second thickness that is greater than the first wall thickness, and
a stopping flange extending radially outward from the tubular body;
providing a panel including a panel aperture, a first surface on a first side of the panel, and a second surface on a second side of the panel;
inserting the through-wall connector through the panel aperture, wherein, when the through-wall connector is inserted into the panel aperture, the raised threaded section extends through the panel aperture, and the stopping flange contacts the second surface of the panel;
securing a threaded nut onto the threaded section to secure the through-wall connector to the panel, wherein, when the threaded nut is secured to the threaded section, a surface of the threaded nut contacts the first surface of the panel.

11. The method of claim 10, wherein both of the first connection interface and the second connection interface comprise radial flanges.

12. The method of claim 11, wherein the radial flanges define a flange diameter, and the raised threaded section defines a threaded section diameter, wherein the threaded section diameter is greater than the flange diameter.

13. The method of claim 10 or of claim 11 or claim 12, wherein the panel aperture is a D-shaped aperture, wherein the threaded section includes a flat portion to engage the D-shaped aperture to at least partially limit a rotation of the through-wall connector relative to the panel.

14. The method of claim 10 or of any of claims 11 to 13, wherein the through-wall connector is formed from an injection-molded plastic.

15. The method of claim 10 or of any of claims 11 to 14, wherein the through-wall connector further incudes a third connection interface including a third opening, the third connection interface positioned between the first and second connection interfaces, the third opening being in communication with the interior channel.
